# EUROPEAN PATENT APPLICATION

(11) **EP 4 625 441 A1**
(43) Date of publication of application: **01.10.2025**
(21) Application number: 23893733.8
(22) Date of filing: 17.11.2023
(51) Int. Cl.: H01B 7/08, H01B 7/17, H01B 7/18, H01B 7/02

(54) **FLEXIBLE SUBSTRATE WIRE HARNESS AND AUTOMOBILE**

(30) Priority: 22.11.2022 CN 202211468873
(71) Applicant: Changchun Jetty Automotive Technology Co., Ltd., Changchun City, Jilin Province 130000 (CN)
(72) Inventor: WANG, Chao, Changchun, Jilin 130000 (CN)
(74) Representative: Boult Wade Tennant LLP
(86) International application number: PCT/CN2023/132231
(87) International publication number: WO 2024/109643

(57) **Abstract**

The present disclosure provides a flexible substrate wire harness and an automobile. The flexible substrate wire harness includes a flexible substrate and conductor cores. The flexible substrate is provided with a plurality of wire core channels separated from each other. The conductor cores are disposed in the wire core channels and fixedly connected to the flexible substrate. The technical problem that the wire harness is inconvenient to be bent and the insulating layer is prone to damage during bending is solved.

## Description

### CROSS-REFERENCE TO RELATED APPLICATIONS

The present disclosure claims priority to Chinese Invention Patent Application No. 202211468873.6, filed November 22, 2022, and entitled "a flexible substrate wire harness and an automobile".

### TECHNICAL FIELD

The present disclosure relates to a technical field of automobile components, and particularly to a flexible substrate wire harness and an automobile.

### BACKGROUND

Automotive electrical appliances and other control systems include a large number of wire harnesses, and various types of wire harnesses and pipelines run through the vehicle body. The wire harness generally includes a conductor core and an insulating layer covering the conductor core. The conductor core is used for current transmission, while the insulating layer, typically made of a resin material, serves to protect the conductor core. At present, the wire harness is inconvenient to be bent, and the insulating layer of the wire harness is prone to damage during bending, which makes it inconvenient to assemble the wire harness and increases the difficulty of wiring in the automobile.

### SUMMARY

The present disclosure aims to provide a flexible substrate wire harness and an automobile, so as to solve the technical problem that a wire harness is inconvenient to be bent and an insulating layer is prone to damage during bending.

The above objective of the present disclosure can be achieved by adopting the following technical solutions:
The present disclosure provides a flexible substrate wire harness, including a flexible substrate and conductor cores. The flexible substrate is provided with a plurality of wire core channels separated from each other. The conductor cores are disposed in the wire core channels and fixedly connected to the flexible substrate.

In an exemplary embodiment, a ratio of a thickness of the flexible substrate on an upper side of the wire core channel to a thickness of the flexible substrate on a lower side of the wire core channel ranges from 0.5 to 2.

In an exemplary embodiment, the flexible substrate is cylindrical.

In an exemplary embodiment, the flexible substrate is in a shape of an annular cylinder, and a plurality of the flexible substrates are nested one inside another; and the wire core channels are formed between adjacent flexible substrates, or formed in the flexible substrates.

In an exemplary embodiment, the flexible substrate is in the shape of a wound cylinder, in which the core channels are formed.

The present disclosure provides an automobile, including the aforementioned flexible substrate wire harness.

The present disclosure has the following characteristics and advantages:
The flexible substrate provides protection and insulation for the conductor cores, and can be easily bent while not easy to be damaged, making the flexible substrate wire harness can be bent more freely and flexibly during assembly, thus reducing the difficulty of wiring in the automobile.

### BRIEF DESCRIPTION OF THE DRAWINGS

The following drawings are only for schematic illustration and explanation of the present disclosure, rather than limiting the scope of the present disclosure. In the drawings:
FIGS. 1 to 4 illustrate structural diagrams of a flexible substrate wire harness of the present disclosure;
FIGS. 5 to 7 illustrate diagrams of a connection device in a flexible substrate wire harness of the present disclosure;
FIGS. 8 to 16 illustrate structural diagrams of a flexible substrate wire harness according to other embodiments of the present disclosure; and
FIG. 17 illustrates a structural diagram of a flexible substrate wire harness according to still another embodiment of the present disclosure.

### DETAILED DESCRIPTION OF THE EMBODIMENTS

For a clearer understanding of the technical features, objectives and effects of the present disclosure, specific embodiments of the present disclosure will now be described with reference to the drawings. In the description of the present disclosure, "a plurality of" means two or more unless otherwise specified.

### Solution 1

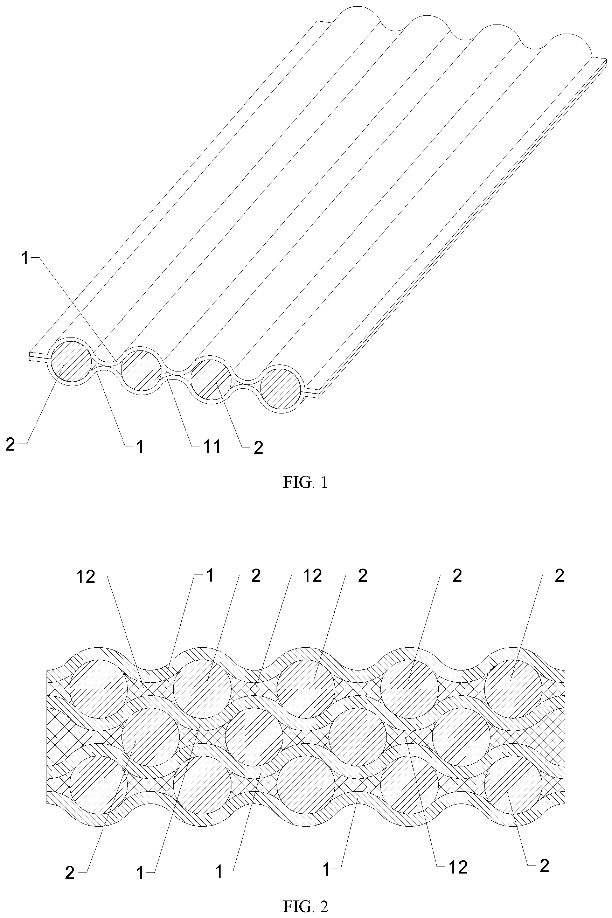

The present disclosure provides a flexible substrate wire harness as illustrated in FIGS. 1 to 12, including a flexible substrate and conductor cores 2. The flexible substrate is provided with a plurality of wire core channels 11 separated from each other. The conductor cores 2 are disposed in the wire core channels 11 and fixedly connected to the flexible substrate. The flexible substrate protects and insulates the conductor cores 2, and may be bent easily while being not prone to damage, so that the flexible substrate wire harness can be bent more freely and flexibly during assembly, thus reducing the difficulty of wiring in an automobile.

In an embodiment, the wire core channels 11 are formed between adjacent flexible substrates. As illustrated in FIGS. 1 and 2, a plurality of the flexible substrates may be stacked, with the conductor cores 2 placed between the adjacent flexible substrates, so that the flexible substrates isolate the conductor cores 2 from the external environment, thereby guaranteeing the insulation of the conductor cores 2 from the external environment.

Further, a plurality of wire core channels 11 are disposed between the adjacent flexible substrates. As illustrated in FIG. 1, the adjacent flexible substrates are attached to each other to separate the adjacent wire core channels 11 in a same layer, preventing contact between adjacent conductor cores 2 in a same layer to ensure insulation between the conductor cores 2. The adjacent flexible substrates may be attached to each other by means of gluing and/or crimping. During the production of the flexible substrate wire harness, firstly, the conductor cores 2 may be arranged between the adjacent flexible substrates. Next, the flexible substrates are attached to each other in positions between adjacent conductor cores 2. During production, only the positions of the conductor cores 2 on the flexible substrates need to be controlled, and the positions of the conductor cores 2 are used as references to control the attachment positions of the flexible substrates, so that the production control is convenient, which is conducive to improving the production efficiency and the product quality.

In another embodiment, as illustrated in FIG. 2, the flexible substrate wire harness includes insulating spacers 12 disposed between adjacent flexible substrates. The adjacent wire core channels 11 in a same layer are separated by the insulating spacers 12, and the adjacent conductor cores 2 in a same layer are separated by the insulating spacers 12 without being in contact with each other, thereby guaranteeing the insulation performance between the conductor cores 2. The insulating spacer 12 may be formed by means of filling. For example, fluid such as varnish is injected between adjacent flexible substrates, and the varnish between the conductor cores 2 solidifies to form the insulating spacers 12.

As illustrated in FIG. 1, a thickness of the flexible substrate on an upper side of the wire core channel may be the same as or different from that of the flexible substrate on a lower side of the wire core channel. Specifically, the thickness of the flexible substrate on the upper side of the wire core channel is greater than that of the flexible substrate on the lower side of the wire core channel, or the thickness of the flexible substrate on the upper side of the wire core channel is less than that of the flexible substrate on the lower side of the wire core channel. Among the flexible substrates on the upper side and the lower side of the wire core channel, the thicker flexible substrate has a higher wear resistance and a higher breakdown voltage. During mounting, a side with the thicker flexible substrate may be placed in a harsh environment, which improves the performance of the flexible substrate wire harness during use.

Further, a ratio of the thickness of the flexible substrate on the upper side of the wire core channel to the thickness of the flexible substrate on the lower side of the wire core channel ranges from 0.5 to 2, that is, in the flexible substrate wire harness illustrated in FIG. 1, a thickness difference between the flexible substrates on the upper side and the lower side of the wire core channel is not more than 100%, ensuring both wear resistance and breakdown resistance while avoiding raw material waste and processing time.

The materials of the flexible substrates on the upper and lower sides of the wire core channel may be the same or different. The wear resistance of the flexible substrate is influenced by many factors, such as the material and the thickness. The wear resistance of the flexible substrate on the upper side of the wire core channel is greater than that of the flexible substrate on the lower side of the wire core channel, or the wear resistance of the flexible substrate on the upper side of the wire core channel is less than that of the flexible substrate on the lower side of the wire core channel.

In an embodiment, the wire core channel 11 is formed in a fabric-based substrate 1. For example, at least one wire core channel 11 is disposed in a complete fabric-based substrate 1, and the conductor core 2 passes through the wire core channel 11. The material of the flexible substrate may be one or more selected from a group consisting of polyvinyl alcohol, polyester, polyimide, polyethylene naphthalate, paper sheets and a textile material. Exemplarily, the flexible substrate is made of a textile material.

Further, the flexible substrate is a fabric-based substrate 1. There are also many ways to dispose the wire core channel 11 in the fabric-based substrate 1: reserving the wire core channel 11 when weaving the fabric-based substrate 1; or reweaving and sewing the fabric-based substrate 1 to envelop and form the wire core channel 11.

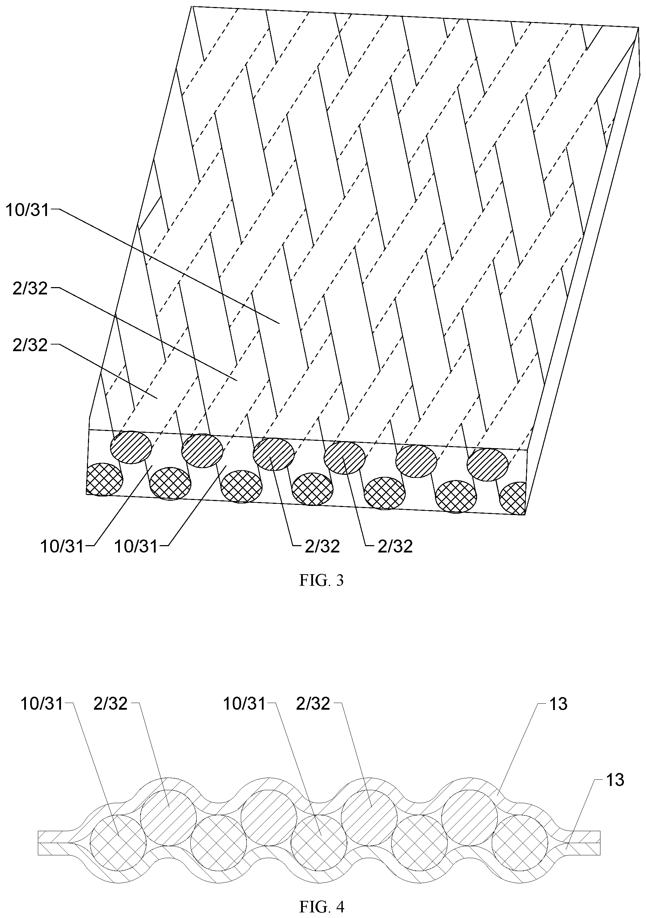

Considering that some signal-transmitting wire harnesses in the automobile are used to transmit microcurrent and have conductors with small cross-sectional areas, the inventor has made an improvement: as illustrated in FIGS. 3 and 4, the conductor cores 2 are woven into the wire core channels 11 in the fabric-based substrate 1. Specifically, during the weaving of the fabric-based substrate 1, the conductor cores 2 are woven together with the fabric-based fibers as a whole to form the fabric-based substrate 1, in which the spaces occupied by the conductor cores 2 are the wire core channels 11. At least some of the fabric-based fibers are insulating fibers 10, which separate the conductor cores 2 to ensure their insulation. As illustrated in FIG. 3, the conductor cores 2 are woven as warp threads 31 and the insulating fibers 10 are woven as weft threads 32, with insulating fibers 10 separating the conductive cores 2, allowing them to conduct microcurrents.

The diameter of the conductor core 2 is similar to that of the insulating fiber 10. By weaving the conductor cores 2 into the fabric-based substrate 1, not only circuit loops are laid out, but also the adjacent conductor cores 2 are insulated by the insulating fibers 10 of the fabric-based substrate 1. The flexible substrate wire harness utilizes mature weaving process to quickly layout circuit loops, which is faster and more convenient than manual wiring and even printed circuit board wiring, thereby shortening processing time. The flexible substrate wire harness can be processed using existing weaving equipment, thus reducing the cost of the wire harness.

Increasing the number of layers of the insulating fibers 10 in the fabric-based substrate lensures that the insulating fibers 10 can cover the conductor cores 2, achieving insulation between the conductor cores 2 and the external environment. In another embodiment, the flexible substrate wire harness includes an insulation protective layer 13 as illustrated in FIG. 4, which covers the conductor cores 2 to ensure the insulation of the conductor cores 2 from the external environment. The insulation protective layer 13 may be fabric or an insulating paint layer, etc.

The conductor cores 2 may be distributed in multiple layers, so as to arrange more conductor cores 2 in a small space and improve the distribution density of the conductor cores 2. Two adjacent layers of the conductor cores 2 may be separated by the fabric-based substrate 1 or the insulation protective layer 13.

In an embodiment, the plurality of conductor cores in the flexible substrate wire harness may have multiple cross-sectional shapes, that is, at least one conductor core has a cross-sectional shape that is different from those of other conductor cores. Further, the cross-sectional shapes of the plurality of conductor cores in the flexible substrate wire harness are different from each other. Further, the cross-sectional shape of the conductor core is one or more selected from the group consisting of a circle, an ellipse, a rectangle, a polygon, an A-shape, a B-shape, a D-shape, an M-shape, an N-shape, an O-shape, an S-shape, an E-shape, an F-shape, an H-shape, a K-shape, an L-shape, a T-shape, a P-shape, a U-shape, a V-shape, a W-shape, an X-shape, a Y-shape, a Z-shape, an semi-arc shape, an arc shape, and a wave shape.

In an embodiment, a ratio of a distance between two of the conductor cores to a diameter of the conductor core ranges from 0.1 to 10, so as to arrange as many conductor cores as possible in a unit area and avoid discharging. Exemplarily, the material of the conductor core may be one or more selected from the group consisting of carbon, aluminum, silver and copper.

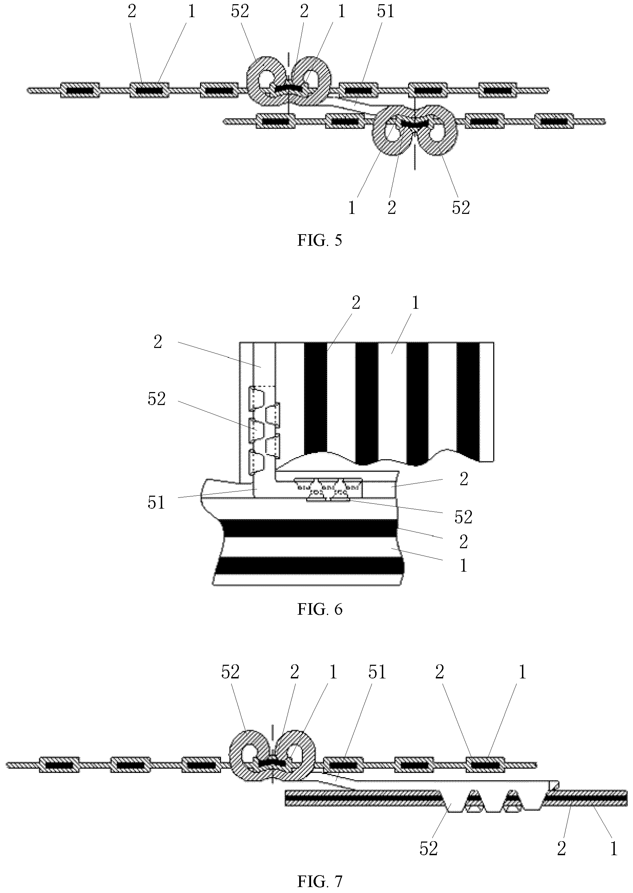

Further, the flexible substrate wire harness includes a connection device connected to the conductor cores 2 of multiple different layers. The connection device includes a connection piece 51, two ends of which are connected to the conductor cores 2 of different layers, respectively, so that the conductor cores 2 of different layers can be electrically connected. As illustrated in FIGS. 5 to 7, the connection device further includes a crimping wing 52, and the connection piece 51 is connected with the crimping wing 52; by means of crimping, the crimping wing 52 pierces the fabric-based substrate 1 and contacts the conductor core 2, so as to realize the electrical connection between the connection piece 51 and the conductor core 2. In another embodiment, part of the fabric-based substrate 1 is peeled off, and the conductor core 2 and the connection piece 51 are connected by welding.

The connection device further includes a curled crimping wing 52 connected to the connection piece 51. By means of crimping, the curled crimping wing 52 punctures the fabric-based substrate 1 and comes into contact with the conductor core 2, so as to realize the electrical connection between the connection piece 51 and the conductor core 2. In another embodiment, part of the fabric-based substrate 1 is stripped off, and the conductor core 2 and the connecting piece 51 are connected by means of welding.

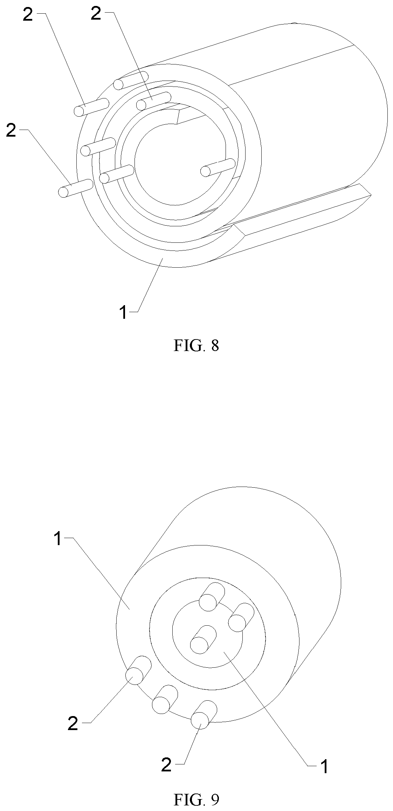

As illustrated in FIGS. 8 to 12, the fabric-based substrate 1 is cylindrical, offering better protection for the conductor cores 2 and allowing for the arrangement of more conductor cores 2. In an embodiment, as illustrated in FIGS. 9 to 12, the fabric-based substrate 1 is in the shape of an annular cylinder, and a plurality of fabric-based substrates 1 are nested one inside another. Further, the wire core channels 11 are formed between adjacent fabric-based substrates 1, or formed in the fabric-based substrates 1. In another embodiment, as illustrated in FIG. 8, the fabric-based substrate 1 is in the shape of a wound cylinder, in which the core channels 11 are formed. In another embodiment, the fabric-based substrate 1 is in the shape of a wound cylinder, and is wound to form the wire core channels 11. Specifically, the conductor cores 2 are arranged between inner and outer layers of the fabric-based substrate 1. During production and processing, the conductor cores 2 are placed on the fabric-based substrate 1 during the process of winding the fabric-based substrate 1 from inside to outside.

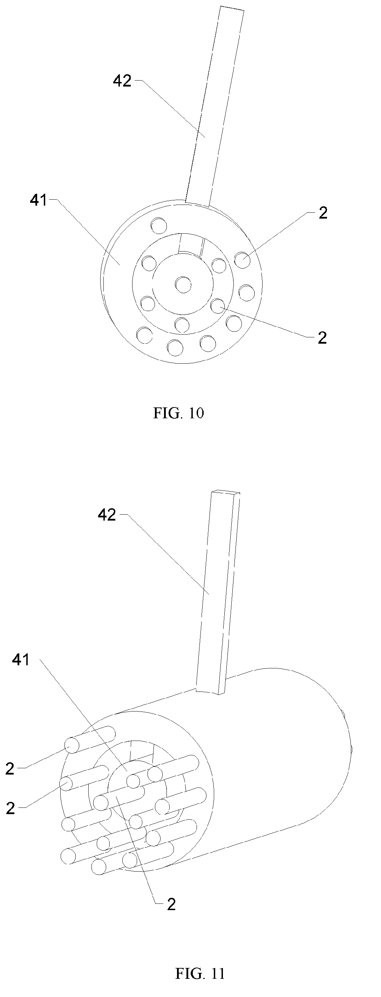

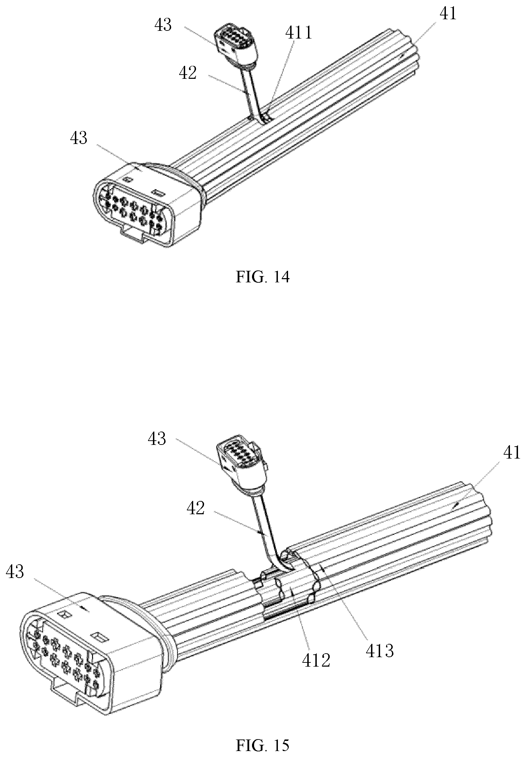

As illustrated in FIGS. 10 to 16, the fabric-based substrate 1 includes a trunk 41 and a branch 42, which are internally provided with the conductor cores 2 respectively. In an embodiment, a free end of the trunk 41 and a free end of the branch 42 are provided with connectors 43 for electrical connection with an external circuit.

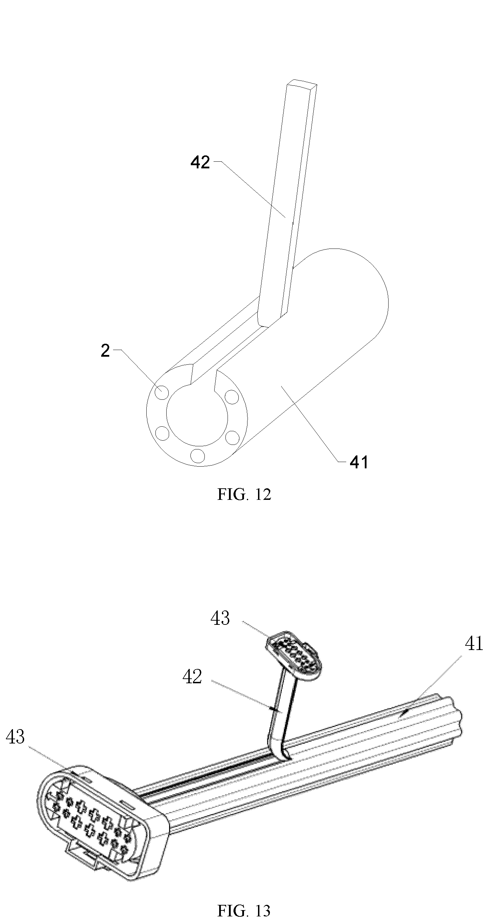

As illustrated in FIGS. 12 and 13, the trunk 41 is cylindrical, and the branch 42 is located on an outer layer of the cylindrical trunk 41. The branch 42 is formed by cutting according to a branch loop. As illustrated in FIGS. 10-11 and 14-15, the trunk 41 is cylindrical, and a sidewall of the trunk 41 is provided with a branch opening 411, through which the branch 42 protrudes. Specifically, when the cylindrical trunk 41 is composed of multiple layers including a trunk outer layer 412 and a trunk inner layer 413, and the branch 42 is located in the trunk inner layer 413, the fabric-based substrate 1 and the conductor core 2 of the trunk inner layer 413 may be cut according to the branch loop to form the branch 42 which is led out from the branch opening 411.

The fabric-based substrate 1 is elastic, with the conductor core 2 disposed in its wire core channel 11, so that the conductor core 2 can be bent or return to its original shape along with the stretching or rebounding of the fabric-based substrate 1.

In an embodiment of the present disclosure, the fabric-based substrate 1 includes an insulating fiber product and insulating varnish which is impregnated into the insulating fiber product. The raw material of the insulating fiber product may be one or more selected from the group consisting of cotton, hemp, silk, glass fiber, asbestos fiber, and synthetic fiber. The synthetic fiber includes one or more selected from the group consisting of polyamide 6 fiber, polyacrylonitrile fiber, polyester fiber, polypropylene fiber, polyvinyl formal fiber, and polytetrafluoroethylene fiber. The insulating paint includes one or more selected from the group consisting of oil-based paint, asphalt alkyd paint, epoxy ester paint, silicone paint, methyl silicone rubber enamel paint, and polyimide paint.

The materials of the flexible substrates on the upper side and the lower side of the wire core channel may be the same or different. Further, the materials of the flexible substrates on the upper side and the lower side of the wire core channel are different from each other, so as to better adapt to the characteristics of the mounting environment.

Exemplarily, a temperature resistance grade of the fabric-based substrate 1 is greater than or equal to 100°C, and a withstand voltage value of the fabric-based substrate 1 is greater than or equal to 0.4 KV.

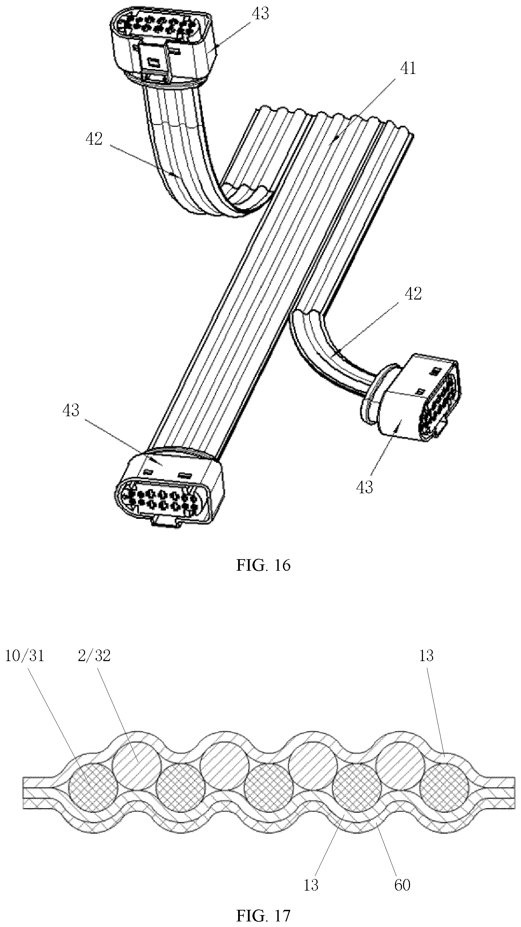

In an embodiment, at least part of an outer wall of the flexible substrate is provided with a shock absorber, which provides shock absorption and protection for both the vehicle body and the flexible substrate wire harness. The shock absorber may be disposed on a mounting side of the flexible substrate wire harness, that is, when the flexible substrate wire harness is mounted and arranged, the flexible substrate is in contact with the vehicle body through the shock absorber, so as to achieve a better protective effect. As illustrated in FIG. 17, the shock absorber is a shock-absorbing layer 60 adhered or integrally injection-molded onto the flexible substrate. Exemplarily, the shock-absorbing layer 60 may be made of elastic foam plastic or rubber.

### Solution 2

The present disclosure provides an automobile, which includes the aforementioned flexible substrate wire harness. The automobile has the technical features and the advantageous effects of the aforementioned flexible substrate wire harness, and thus will not be repeated here.

**In** an exemplary embodiment, at least part of the flexible substrate is set according to the shape of the vehicle body and attached to the vehicle body. When the flexible substrate wire harness is mounted on the vehicle body, at least part of the flexible substrate is attached to the vehicle body, thereby enabling the flexible substrate wire harness to be arranged along the shape of the vehicle body, which is beneficial to saving the internal space of the vehicle body, facilitates the mounting and arrangement of the flexible substrate wire harness on the vehicle body, and improves the positional stability and the reliability during long-term use.

Those described above are only illustrative embodiments of the present disclosure, and are not intended to limit the scope thereof. Any equivalent change or modification made by those skilled in the art without departing from the concept and the principles of the present disclosure should fall within the protection scope of the present disclosure.

## Claims

1. A flexible substrate wire harness, comprising a flexible substrate and conductor cores, the flexible substrate being provided with a plurality of wire core channels separated from each other, and the conductor cores being disposed in the wire core channels and fixedly connected to the flexible substrate.

2. The flexible substrate wire harness according to claim 1, wherein the wire core channels are formed in the flexible substrate, and the conductor cores are woven into the wire core channels in the flexible substrate.

3. The flexible substrate wire harness according to claim 1, wherein the plurality of conductor cores in the flexible substrate wire harness have multiple cross-sectional shapes.

4. The flexible substrate wire harness according to claim 3, wherein the cross-sectional shapes of the plurality of conductor cores in the flexible substrate wire harness are different from each other.

5. The flexible substrate wire harness according to claim 1, wherein a ratio of a distance between two of the conductor cores to a diameter of the conductor core ranges from 0.1 to 10.

6. The flexible substrate wire harness according to any one of claims 1 to 5, wherein the conductor cores are distributed in multiple layers; and the flexible substrate wire harness comprises a connection device connected to the conductor cores of multiple different layers.

7. The flexible substrate wire harness according to claim 1, wherein the wire core channels are formed between adjacent flexible substrates.

8. The flexible substrate wire harness according to claim 7, wherein a wear resistance of the flexible substrate on an upper side of the wire core channel is greater than that of the flexible substrate on a lower side of the wire core channel, or the wear resistance of the flexible substrate on the upper side of the wire core channel is less than that of the flexible substrate on the lower side of the wire core channel.

9. The flexible substrate wire harness according to claim 7, wherein a material of the flexible substrate on an upper side of the wire core channel is different from that of the flexible substrate on a lower side of the wire core channel.

10. The flexible substrate wire harness according to claim 7, wherein a thickness of the flexible substrate on an upper side of the wire core channel is greater than that of the flexible substrate on a lower side of the wire core channel, or the thickness of the flexible substrate on the upper side of the wire core channel is less than that of the flexible substrate on the lower side of the wire core channel.

11. The flexible substrate wire harness according to claim 7, wherein a ratio of a thickness of the flexible substrate on an upper side of the wire core channel to a thickness of the flexible substrate on a lower side of the wire core channel ranges from 0.5 to 2.

12. The flexible substrate wire harness according to claim 1, wherein the flexible substrate is cylindrical.

13. The flexible substrate wire harness according to claim 12, wherein the flexible substrate is in a shape of an annular cylinder, and a plurality of flexible substrates are nested one inside another; and
the wire core channels are formed between adjacent flexible substrates, or formed in the flexible substrates.

14. The flexible substrate wire harness according to claim 12, wherein the flexible substrate is in a shape of a wound cylinder, in which the core channels are formed.

15. The flexible substrate wire harness according to claim 12, wherein the flexible substrate is in the shape of a wound cylinder and is wound to form the wire core channels.

16. The flexible substrate wire harness according to claim 1, wherein at least part of an outer wall of the flexible substrate is provided with a shock absorber.

17. The flexible substrate wire harness according to claim 16, wherein the shock absorber is a shock-absorbing layer adhered or integrally injection-molded onto the flexible substrate.

18. The flexible substrate wire harness according to claim 16, wherein the shock absorber is made of elastic foam plastic or elastic rubber.

19. The flexible substrate wire harness according to claim 1, wherein the flexible substrate comprises a trunk and a branch, which are internally provided with the conductor cores respectively.

20. The flexible substrate wire harness according to claim 19, wherein a free end of the trunk and a free end of the branch are provided with connectors for electrical connection with an external circuit.

21. The flexible substrate wire harness according to claim 1, wherein a material of the conductor core is one or more of carbon, aluminum, silver and copper.

22. The flexible substrate wire harness according to claim 1, wherein a material of the flexible substrate is one or more of polyvinyl alcohol, polyester, polyimide, polyethylene naphthalate, paper sheets and a textile material.

23. The flexible substrate wire harness according to claim 1, wherein the flexible substrate is a fabric-based substrate.

24. The flexible substrate wire harness according to any one of claims 12 to 15, wherein the flexible substrate comprises a trunk and a branch, which are internally provided with the conductor cores respectively; the trunk is cylindrical, and a sidewall of the trunk is provided with a branch opening for arranging the branch.

25. The flexible substrate wire harness according to claim 23, wherein the flexible substrate comprises an insulating fiber product and insulating varnish which is impregnated into the insulating fiber product.

26. An automobile, comprising the flexible substrate wire harness according to any one of claims 1 to 25.

27. The automobile according to claim 26, wherein at least part of the flexible substrate is set according to a shape of a vehicle body and attached to the vehicle body.
